(19) Europäisches Patentamt
European Patent Office
Office européen des brevets

(11) EP 4 768 957 A1

(12) EUROPEAN PATENT APPLICATION

(43) Date of publication:
01.07.2026 Bulletin 2026/27

(21) Application number: 25219306.5

(22) Date of filing: 28.11.2025

(51) International Patent Classification (IPC):
G01R 31/392 (2019.01)      G01R 31/396 (2019.01)

(52) Cooperative Patent Classification (CPC):
G01R 31/392; G01R 31/396

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH LA MA MD TN

(30) Priority: 31.12.2024 KR 20240201721

(71) Applicant: SAMSUNG SDI CO., LTD.
Yongin-si, Gyeonggi-do 17084 (KR)

(72) Inventors:
• PARK, Hyun Ah
  16678 Suwon-si, Gyeonggi-do (KR)
• GO, Hyun Seok
  16678 Suwon-si, Gyeonggi-do (KR)

(74) Representative: Gulde & Partner
Patent- und Rechtsanwaltskanzlei mbB
Berliner Freiheit 2
10785 Berlin (DE)

(54) BATTERY ABNORMALITY DETECTION APPARATUS AND METHOD, AND BATTERY PACK

(57) The present disclosure relates to a battery abnormality detection apparatus and method, and a battery pack, for precisely detecting an abnormal battery cell. A battery abnormality detection apparatus includes a memory (100) configured to store an instruction, and a processor (200) configured to execute the instruction, detect an abnormality of a target battery cell of battery cells based on a cell voltage of the target battery cell, determine (S200) a size of an interquartile range of cell voltages for the battery cells, and analyze a relative behavior of the cell voltage of the target battery cell with respect to the cell voltages for the battery cells based on the size of the interquartile range.

FIG. 7

$$① \ IQR_{T1} = Q1_{T1} - Q3_{T1} = 0.1V$$

$$② \ P_{T1} = |V_{TRG\_T1} - Q1_{T1}| \ / \ IQR_{T1} = 0.15V \ / \ 0.1V = 1.5$$

$$③ \ P_{T1} = |V_{TRG\_T1} - Q3_{T1}| \ / \ IQR_{T1} = 0.2V \ / \ 0.1V = 2$$

EP 4 768 957 A1

**Description**

**BACKGROUND**

**1. Field**

The present disclosure relates to a battery abnormality detection apparatus and battery abnormality detection method, and a battery pack.

**2. Description of the Related Art**

Secondary batteries are batteries that can be charged and discharged, unlike primary batteries that cannot be recharged. Low-capacity secondary batteries are used in small portable electronic devices, such as smartphones, feature phones, laptop computers, digital cameras, and camcorders. High-capacity batteries are widely used as power sources for driving a motor, power storage batteries, and the like in hybrid vehicles, electric vehicles, and the like. Such secondary batteries (e.g., a battery cell) include an electrode assembly including a positive electrode, a negative electrode, a separator interposed between the positive electrode and the negative electrode, a case accommodating the electrode assembly, and electrode terminals electrically connected to the electrode assembly.

Charging and discharging of a battery cell is performed in such a manner that and an electrochemical reaction occurs between the positive electrode, the negative electrode, and an electrolyte injected into the case of the battery cell. The case of the battery cell may be implemented in various shapes, such as a cylindrical shape or a rectangular shape, depending on the purpose of the battery cell.

The above information disclosed in this Background section is for enhancement of understanding of the background of the present disclosure, and therefore, it may contain information that does not constitute related (or prior) art.

**SUMMARY**

The present disclosure is directed to providing a battery abnormality detection apparatus, battery abnormality detection method and a battery pack, which can precisely detect an abnormal battery cell (e.g., a battery cell in which deformation occurs due to an external impact, in which metallic foreign substances are introduced, or in which lithium is precipitated by an electrochemical reaction).

Aspects that the present disclosure intends to achieve are not limited to the above-described aspects, and other aspects that are not described may be clearly understood by those skilled in the art from the following description.

According to an aspect of the present disclosure, there is provided a battery abnormality detection apparatus including a memory configured to store instructions, and a processor that, when executing the instructions, causes the battery abnormality detection apparatus to detect an abnormality of a target battery cell of battery cells based on a cell voltage of the target battery cell, determine a size of an interquartile range of cell voltages for the battery cells, and analyze a relative behavior of the cell voltage of the target battery cell with respect to the cell voltages for the battery cells based on the size of the interquartile range.

The processor may be configured to analyze the relative behavior at a current time point by obtaining a target cell voltage of the target battery cell, determining the size of the interquartile range, and/or determining a parameter indicating a relative position of the target cell voltage with respect to the cell voltages based on the target cell voltage and the size of the interquartile range.

The processor, at a first time point, may be configured to obtain the first target cell voltage of the target battery cell, may be configured to determine a first size of a first interquartile range, and/or may be configured to determine a first parameter indicating a first relative position of the first target cell voltage with respect to the cell voltages based on the first target cell voltage and the first size of the first interquartile range. The processor, at a second time point following the first time point, may be configured to obtain a second target cell voltage of the target battery cell, may be configured to determine a second size of a second interquartile range, and/or may be configured to determine a second parameter indicating a second relative position of the second target cell voltage with respect to the cell voltages based on the second target cell voltage and the second size of the second interquartile range. The processor may be configured to analyze the relative behavior using a difference between the first parameter and the second parameter.

The processor, at the first time point, may be configured to calculate a first difference between a first quartile or a third quartile of the cell voltages of the first interquartile range and the first target cell voltage, and/or may be configured to determine the first parameter by a first ratio of the first difference and the first size of the first interquartile range. The processor, at the second time point, may be configured to calculate a second difference between a first quartile or a third quartile of the cell voltages of the second interquartile range and the second target cell voltage. The processor may be configured to determine the second parameter by a second ratio of the second difference and the second size of the second interquartile range.

The first difference may be between the first target cell voltage and the first quartile of the cell voltages of the first interquartile range when the first target cell voltage is greater than the first quartile, and/or may be between the first target cell voltage and the third quartile of the cell voltages of the first interquartile range ($IQR_{T1}$) when the first target cell voltage ($V_{TRG\_T1}$) is less than the third quartile. The second difference may be between the second target cell voltage and the first quartile of the cell voltages of the second interquartile range when the second target cell voltage is greater than the first quartile, and/or may be between the second target cell voltage and the third quartile of the cell voltages of the second interquartile range when the second target cell voltage is less than the third quartile.

The processor may be configured to determine a first behavior parameter indicating the relative behavior in a first time interval from the first time point to the second time point by using the difference between the first parameter and the second parameter. The processor may be configured to detect the abnormality of the target battery cell by comparing the first behavior parameter with a reference range.

The processor, at a third time point following the second time point, may be configured to obtain a third target cell voltage of the target battery cell. The processor, at a third time point, may be configured to determine a third size of a third interquartile range. The processor, at a third time point, may be configured to determine a third parameter indicating a third relative position of the third target cell voltage with respect to the cell voltages based on the third target cell voltage and the third size. The processor may be configured to determine a second behavior parameter indicating the relative behavior in a second time interval from the second time point to the third time point by using a difference between the second parameter and the third parameter. The processor may be configured to detect the abnormality of the target battery cell by comparing the first behavior parameter and the second behavior parameter with the reference range.

The first time point, the second time point, and the third time point may be determined according to a same state-of-charge (SOC) condition in which an overall SOC of the battery cells has a reference SOC.

The processor, may be configured to determine the first behavior parameter by dividing the difference between the first parameter and the second parameter by a first time compensation factor. The processor may be configured to determine the second behavior parameter by dividing the difference between the second parameter and the third parameter by a second time compensation factor. The first time compensation factor and/or the second time compensation factor may be for normalizing the first behavior parameter and/or the second behavior parameter by compensating for a difference between a first time length between the first time point and the second time point and a second time length between the second time point and the third time point.

The processor, when the size of the interquartile range at the current time point is less than or equal to a reference value, may be configured to determine the size of the interquartile range as the reference value.

According to another aspect of the present disclosure, there is provided a battery pack including a battery including battery cells, and a processor configured to detect an abnormality of a target battery cell of the battery cells based on a cell voltage of the target battery cell, configured to determine a size of an interquartile range of cell voltages of the battery cells, configured to analyze a relative behavior of the cell voltage of the target battery cell with respect to the cell voltages based on the size of the interquartile range, and configured to detect the abnormality of the target battery cell.

According to still another aspect of the present disclosure, there is provided a battery abnormality detection method including determining, by a processor, whether an overall state-of-charge (SOC) of battery cells is equal to a reference SOC, determining, by the processor, a size of an interquartile range of cell voltages of the battery cells, analyzing a relative behavior of a cell voltage of a target battery cell with respect to the cell voltages based on the size of the interquartile range, and detecting an abnormality of the target battery cell when the overall SOC of the battery cells is equal to the reference SOC.

The detecting of the abnormality may be repeatedly performed whenever the overall SOC of the battery cells is set (e.g., formed) as the reference SOC. In the detecting of the abnormality, the processor, at a current time point, may be configured to analyze the relative behavior by obtaining a target cell voltage of the target battery cell, by determining the size of the interquartile range, and/or by determining a parameter indicating a relative position of the target cell voltage with respect to the cell voltages based on the target cell voltage and the size of the interquartile range.

In the detecting of the abnormality, the processor, at a first time point, may be configured to obtain a first target cell voltage of the target battery cell, may be configured to determine a first size of a first interquartile range, and/or may be configured to determine a first parameter indicating a first relative position of the first target cell voltage with respect to the cell voltages based on the first target cell voltage and/or the first size. The processor, at a second time point following the first time point, may be configured to obtain a second target cell voltage of the target battery cell, may be configured to determine a second size of the second interquartile range, and/or may be configured to determine a second parameter indicating a second relative position of the second target cell voltage with respect to the cell voltages based on the second target cell voltage and/or the second size. The processor may be configured to analyze the relative behavior using a difference between the first parameter and the second parameter.

In the detecting of the abnormality, the processor, at the first time point, may be configured to calculate a first difference between a first quartile or a third quartile of the cell voltages of the first interquartile range and the first target cell voltage, and/or may be configured to determine the first parameter by a first ratio of the first difference and the first size. The processor, at the second time point, may be configured to calculate a second difference between the first quartile or the third quartile of the cell voltages of the second interquartile range and the second target cell voltage. The processor may be configured to determine the second parameter by a second ratio of the second difference and the second size.

The first difference may be between the first target cell voltage and the first quartile of the first interquartile range when the first target cell voltage is greater than the first quartile. The first difference may be between the first target cell voltage and the third quartile of the first interquartile range when the first target cell voltage is less than the third quartile. The second difference may be between the second target cell voltage and the first quartile of the second interquartile range when the second target cell voltage is greater than the first quartile. The first difference may be between the second target cell voltage and the third quartile of the second interquartile range when the second target cell voltage is less than the third quartile.

In the detecting of the abnormality, the processor may be configured to determine a first behavior parameter indicating the relative behavior in a first time interval from the first time point to the second time point, e.g. by using the difference between the first parameter and the second parameter. The processor may be configured to detect the abnormality of the target battery cell by comparing the first behavior parameter with a reference range.

In the detecting of the abnormality, the processor, at a third time point following the second time point, may be configured to obtain a third target cell voltage of the target battery cell. The processor, at a third time point following the second time point, e.g. at the third time point, may be configured to determine a third size of a third interquartile range. The processor, at a third time point following the second time point, e.g. at the third time point, may be configured to determine a third parameter indicating a third relative position of the third target cell voltage with respect to the cell voltages based on the third target cell voltage and the third size. The processor, e.g. at a third time point following the second time point, e.g. at the third time point, may be configured to determine a second behavior parameter indicating the relative behavior in a second time interval from the second time point to the third time point, e.g. by using a difference between the second parameter and the third parameter. The processor, e.g. at a third time point following the second time point, e.g. at the third time point, may be configured to detect the abnormality of the target battery cell by comparing the first behavior parameter and the second behavior parameter with the reference range.

In the detecting of the abnormality, the processor, at a third time point following the second time point, may be configured to obtain a third target cell voltage of the target battery cell, may be configured to determine a third size of a third interquartile range, and/or may be configured to determine a third parameter indicating a third relative position of the third target cell voltage with respect to the cell voltages based on the third target cell voltage and the third size.

In the detecting of the abnormality, the processor, e.g. at a third time point following the second time point, e.g. at the third time, may be configured to determine a second behavior parameter indicating the relative behavior in a second time interval from the second time point to the third time point, e.g. by using a difference between the second parameter and the third parameter.

In the detecting of the abnormality, the processor, e.g. at a third time point following the second time point, e.g. at the third time, may be configured to detect the abnormality of the target battery cell by comparing the first behavior parameter and the second behavior parameter with the reference range.

In the detecting of the abnormality, the processor, may be configured to determine the first behavior parameter by dividing the difference between the first parameter and the second parameter by a first time compensation factor. The processor may be configured to determine the second behavior parameter by dividing the difference between the second parameter and the third parameter by a second time compensation factor. The first time compensation factor and the second time compensation factor may be provided for normalizing the first behavior parameter and the second behavior parameter, e.g. by compensating for a difference between a time length between the first time point and the second time point and a time length between the second time point and the third time point.

In the detecting of the abnormality, the processor, when the size of the interquartile range is less than or equal to a reference value, may be configured to determine the size of the interquartile range as the reference value.

## BRIEF DESCRIPTION OF THE DRAWINGS

The following drawings attached to this specification illustrate embodiments of the present disclosure, and further describe aspects of the present disclosure together with the detailed description of the present disclosure. Thus, the present disclosure should not be construed as being limited to the drawings, in which:

FIG. 1 is a view illustrating a prismatic battery cell according to one or more embodiments of the present disclosure;
FIG. 2 is a cross-sectional view illustrating the prismatic battery cell according to one or more embodiments of the present disclosure;
FIG. 3 is a view illustrating a battery module according to one or more embodiments of the present disclosure;

FIGS. 4A and 4B are views illustrating a battery pack according to one or more embodiments of the present disclosure;

FIG. 5 is a view illustrating an example of a circuit structure of a battery management system according to one or more embodiments of the present disclosure;

FIG. 6 is a block diagram illustrating a battery abnormality detection apparatus according to one or more embodiments of the present disclosure;

FIG. 7 is a view illustrating an example of a cell voltage and an interquartile range of the battery cell according to one or more embodiments of the present disclosure; and

FIG. 8 is a flow chart illustrating a battery abnormality detection method according to one or more embodiments of the present disclosure.

## DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the aspects of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the overall list of elements and do not modify the individual elements of the list. When phrases, such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Before going into a detailed description of the embodiments, a battery structure that is a target of abnormality detection in one or more embodiments will first be generally described.

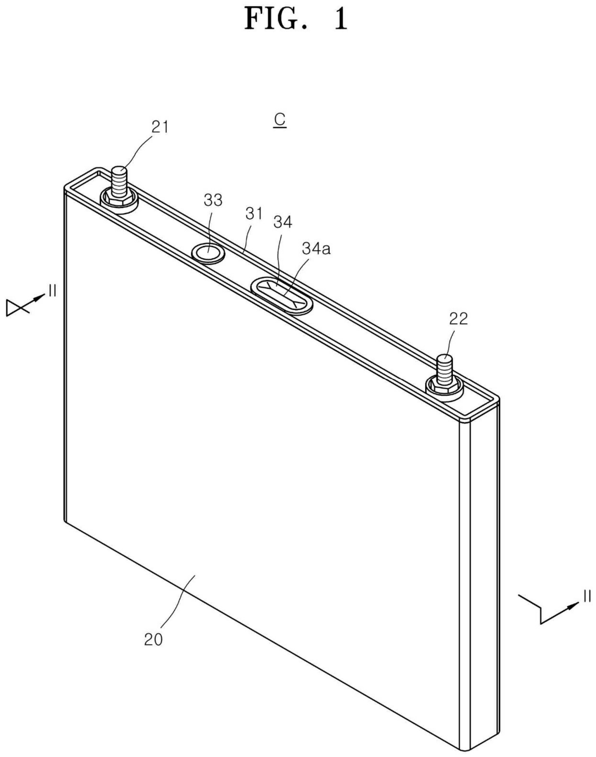

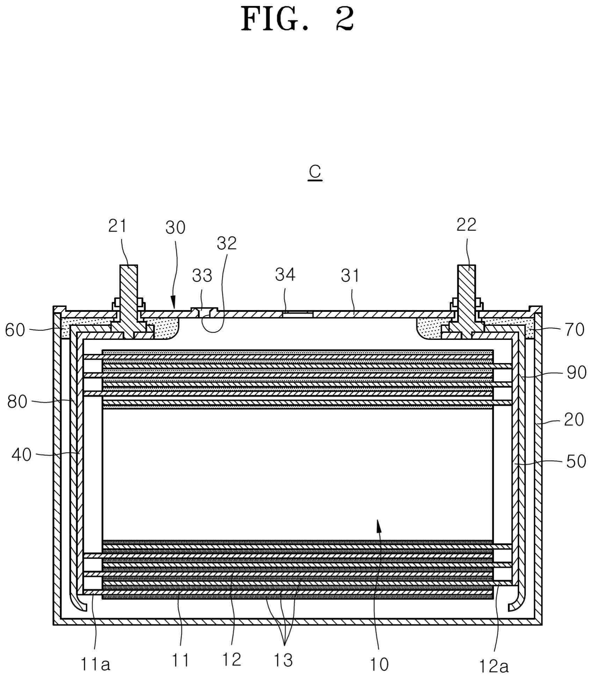

FIG. 1 is a perspective view illustrating a secondary battery according to one or more embodiments, and FIG. 2 is a cross-sectional view along the line II-II in FIG. 1.

Referring to FIGS. 1 and 2, a secondary battery cell C according to one or more embodiments of the present disclosure may include at least one electrode assembly 10 wound with a separator 13 as an insulator between a positive electrode 11 and a negative electrode 12, a case 20 in which the electrode assembly 10 is received (or accommodated) therein, and a cap assembly 30 coupled to an opening of the case 20.

The secondary battery cell C according to one or more embodiments illustrated in FIGS. 1 and 2 will now be described as an example of a prismatic lithium ion secondary battery. The present disclosure is not limited thereto, and suitable aspects described herein may be applied to various other types of batteries, such as lithium polymer batteries and/or cylindrical batteries, for example.

Each of the positive electrode 11 and the negative electrode 12 may include a current collector made of a thin metal foil having a coated portion on which an active material is coated, and a respective uncoated portion 11a, 12a on which no active material is coated (on which an active material is omitted).

In one or more embodiments, the positive electrode 11 and the negative electrode 12 are wound after interposing the separator 13, which is an insulator, therebetween. The present disclosure is not limited thereto, and the electrode assembly 10 may have a structure in which a positive electrode 11 and a negative electrode 12, each made of a plurality of sheets, are alternately stacked with a separator interposed therebetween.

The case 20 may correspond to an overall outer appearance of the secondary battery cell C, and may be made of a conductive metal, such as aluminum, an aluminum alloy, or nickel-plated steel. In one or more embodiments, the case 20 may provide a space in which the electrode assembly 10 is accommodated.

The cap assembly 30 may include a cap plate 31 covering the opening in the case 20, and the case 20 and the cap plate 31 may be made of a conductive material. Positive and negative electrode terminals 21 and 22 electrically connected to the positive electrode 11 and the negative electrode 12, respectively, may be installed to penetrate (or extend through) the cap plate 31, and may protrude outwardly therethrough.

In one or more embodiments, outer peripheral surfaces (e.g., circumferential surfaces) of upper pillars of the positive and negative electrode terminals 21 and 22 protruding outwardly from the cap plate 31 may be threaded, and may be fixed to the cap plate 31 (e.g., by utilizing nuts). However, the present disclosure is not limited thereto, and the positive and negative electrode terminals 21 and 22 may have a rivet structure, and may be riveted or welded to the cap plate 31, for example.

In one or more embodiments, the cap plate 31 may be made of a thin plate, and may be coupled to the opening in the case 20, and an electrolyte injection port 32 (into which a sealing stopper 33 may be installed) may be located (e.g., formed) in the cap plate 31, and a vent portion 34 having a notch 34a may be installed or included.

The positive and negative electrode terminals 21 and 22 may be respectively electrically connected to current collectors including first and second current collectors 40 and 50 (herein referred to as positive and negative current collectors) by being bonded or coupled (e.g., by welding) to the positive uncoated portion 11a and to the negative electrode uncoated portion 12a.

For example, the positive and negative electrode terminals 21 and 22 may be coupled by welding to the positive and negative electrode current collectors 40 and 50, respectively. The present disclosure is not limited thereto, and the positive and negative electrode terminals 21 and 22 and the positive and negative electrode current collectors 40 and 50 may be respectively integral (e.g., integrally formed) in one or more embodiments.

In one or more embodiments, an insulation member may be installed between the electrode assembly 10 and the cap plate 31. The insulation member may include first and second lower insulation members 60 and 70, and each of the first and second lower insulation members 60 and 70 may also have a portion located between the electrode assembly 10 and the case 20.

According to one or more embodiments of the present disclosure, an end of a separation member may face a side of the electrode assembly 10 and may be installed between the insulation member and the positive or negative electrode terminals 21 and 22.

In one or more embodiments, the separation member may include first and second separation members 80 and 90. First ends of the first and second separation members 80 and 90 installed to face a side of the electrode assembly 10 may be respectively installed between the first and second lower insulation members 60 and 70 and the positive and negative electrode terminals 21 and 22.

In one or more embodiments, the positive and negative electrode terminals 21 and 22, which may be coupled by welding to the positive and negative electrode current collectors 40 and 50, may be coupled to first ends of the first and second lower insulation members 60 and 70 and the first and second separation members 80 and 90.

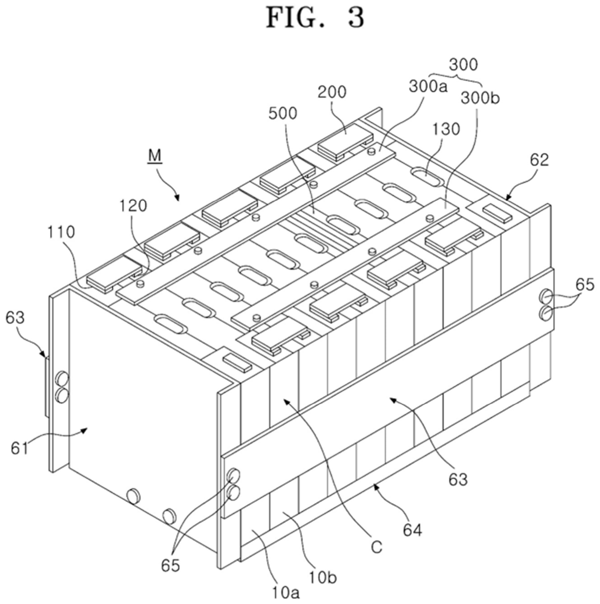

FIG. 3 is a perspective view illustrating a battery module according to one or more embodiments of the present disclosure.

Referring to FIG. 3, a battery module M according to one or more embodiments of the present disclosure includes electrode units/terminal portions 110 and 120, a plurality of battery cells C arranged in a direction, a connection tab 200 connecting one battery cell 10a to an adjacent battery cell 10b, and a protection circuit module 300 having an end connected to the connection tab 200. In one or more embodiments, the protection circuit module 300 may include a battery management system (BMS). Further, the connection tab 200 may include a body portion in contact with respective ones of the terminal portions 110 and 120 between the adjacent battery cells 10a and 10b, and an extension portion extending from the body portion and connected to the protection circuit module 300. The connection tab 200 may be, for example, a bus bar.

Each battery cell C may include a battery case, an electrode assembly received (or accommodated) in the battery case, and an electrolyte. The electrode assembly and the electrolyte react electrochemically to store and release (e.g., generate) energy. Electrode units, or terminal portions, 110 and 120 that are electrically connected to the connection tab 200, and a vent 130 as a discharge passage for gas generated inside the battery case, may be provided on a side of (e.g., an upper side of) the battery cell C. The terminal portions 110 and 120 of the battery cell C may respectively be a positive electrode terminal 110 and a negative electrode terminal 120 having different polarities from each other, and respective ones of the terminal portions 110 and 120 of the adjacent battery cells 10a and 10b may be electrically connected to each other in series or in parallel by the connection tab 200, to be described in further detail below. Although a serial connection is illustrated as an example, the connection structure is not limited thereto, and any of various connection structures may be employed as desired or suitable. In one or more embodiments, a number and arrangement of battery cells is not limited to the structure shown in FIG. 3 and may be changed as desired or suitable.

The plurality of battery cells C may be arranged in (e.g., may be stacked in) a direction such that wide surfaces of the battery cells C face each other, and the plurality of battery cells C may be fixed by housing components 61, 62, 63, and 64. The housing components 61, 62, 63, and 64 may include a pair of end plates 61 and 62 facing respective wide surfaces of the battery cells C, and a side plate (or side plates) 63 and a bottom plate 64 connecting the pair of end plates 61 and 62 to each other. The side plate 63 may support side surfaces of the battery cells C, and the bottom plate 64 may support bottom surfaces of the battery cells C. In one or more embodiments, the pair of end plates 61 and 62, the side plate 63, and the bottom plate 64 (e.g., the housing components) may be connected by bolts 65 and/or any other suitable fastening members and methods.

The protection circuit module 300 may have electronic components and protection circuits mounted thereon, and may be electrically connected to connection tabs 200, as will be described in further detail below. In one or more embodiments, the protection circuit module 300 includes a first protection circuit module 300a and a second protection circuit module 300b extending in different locations along the direction in which the plurality of battery cells C are arranged. The first protection circuit module 300a and the second protection circuit module 300b may be spaced by a suitable interval (e.g., a predetermined interval) from each other, and may be arranged parallel to each other to be electrically connected to adjacent connection tabs 200, respectively. In one or more embodiments, for example, the first protection circuit module 300a extends on one side of the upper portion of the plurality of battery cells C along the direction in which the plurality of battery cells C is arranged, and the second protection circuit module 300b extends on another side of the upper portion of the plurality of battery cells C along the direction in which the plurality of battery cells C is arranged. The second protection circuit module 300b may be spaced by a suitable interval (e.g., a predetermined interval) from the first protection circuit module 300a with the vents 34 interposed therebetween, and may be arranged parallel to the first protection circuit module 300a. As such, the two protection circuit modules may be arranged in parallel and spaced apart from each other in the direction in which the plurality of battery cells C is arranged, thereby reducing or minimizing an area of a printed circuit board (PCB) constituting the protection circuit module 300. By separately configuring the protection circuit module 300 into two protection circuit modules, an unnecessary PCB area can be reduced or minimized. The first protection circuit module 300a and the second protection circuit module 300b may be connected to each other by a conductive connection member 500. A side of the conductive connection member 500 is connected to the first protection circuit module 300a, and another side of the conductive connection member 500 is connected to the second protection circuit module 300b such that the two protection circuit modules 300a and 300b can be electrically connected with each other.

The connection may be performed by any of soldering, resistance welding, laser welding, projection welding, and/or any other suitable connection methods.

In one or more embodiments, the connection member 500 may be, for example, an electrical wire. In one or more embodiments, the connection member 500 may be made of a material having elasticity or flexibility. Through the connection member 500, it may be possible to check and manage whether the voltage, temperature, and/or current of the battery cells C are normal. For example, the information received by the first protection circuit module 300a from connection tabs adjacent to the first protection circuit module 300a, such as voltage, current, and/or temperature, and the information received from connection tabs adjacent to the second protection circuit module 300b, such as voltage, current, and/or temperature, may be integrated and managed by the protection circuit module 300 through the connection member 500.

In one or more embodiments, if the battery cell C swells, impacts may be absorbed by the elasticity or flexibility of the connection member 500, thereby reducing or preventing damage to the first and second protection circuit modules 300a and 300b.

A shape and structure of the connection member 500 is not limited to the shape and structure shown in FIG. 3.

As described above, because the protection circuit module 300 is provided as the first and second protection circuit modules 300a and 300b, the area of the PCB constituting the protection circuit module can be reduced or minimized, and a space inside the battery module can be secured, which improves work efficiency by facilitating fastening work for connecting the connection tab 200 and the protection circuit module 300 and repair work if (or when) an abnormality is detected in the battery module M.

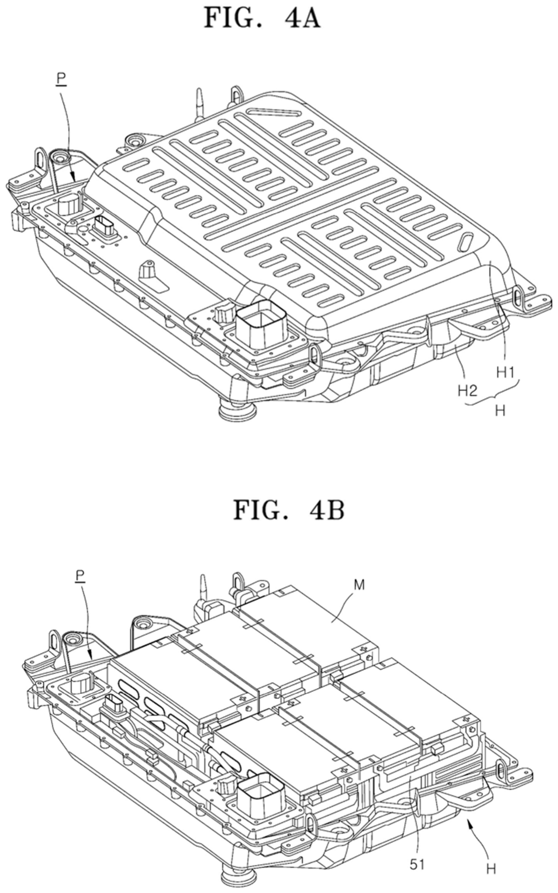

FIGS. 4A and 4B are views illustrating a battery pack according to one or more embodiments of the present disclosure.

A battery pack P may include a plurality of battery modules M and a housing H for accommodating the plurality of battery modules M. For example, the housing H may include first and second housing components H1 and H2 coupled through the plurality of battery modules M. The plurality of battery modules M may be electrically connected to each other using a bus bar 51, and the plurality of battery modules M may be electrically connected to each other in a series, in parallel, or in mixed series-parallel method, thereby obtaining desired (e.g., required or suitable) electrical output.

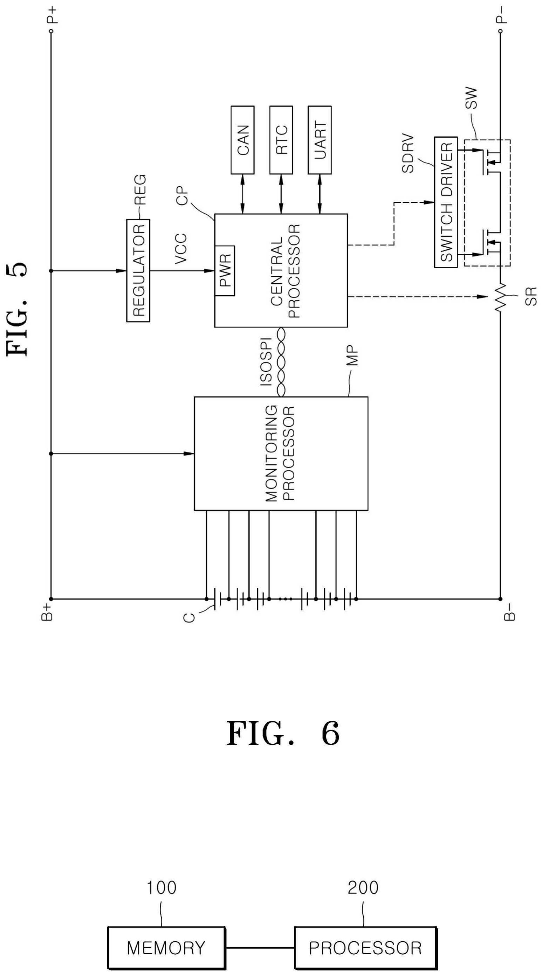

FIG. 5 is a view illustrating an example of a circuit structure of a battery management system according to one or more embodiments of the present disclosure. A battery management system (BMS) according to FIG. 5 may be applied to, for example, an electric vehicle, and may include a battery pack P along with a battery cell (or battery module). To help understand the embodiments, a BMS circuit structure of one or more embodiments will first be described.

Referring to FIG. 5, the BMS may include a monitoring processor MP, a central processor CP, a shunt resistor SR, a charge/discharge switch SW, a switch driver SDRV, and a regulator REG, and may be configured to be electrically connected to a plurality of battery cells C that are connected in series with each other.

The monitoring processor MP may correspond to an analog front end (AFE) integrated circuit (IC) that monitors the state of each battery cell C, and that performs battery cell control operations based on the monitoring results. For example, the monitoring processor MP may be configured to monitor the voltage, current, temperature, and a state of charge (SOC) of the battery cells C, and may perform control operations, such as balancing control, temperature control, and charge/discharge control of the battery cells C based on the monitoring results, or may perform protection operations, such as controlling the charge/discharge switch SW to reduce or prevent over-discharge or over-charge. The state data of the battery cells C (e.g., voltage, current, temperature, and SOC of the battery cells C) obtained by the monitoring processor MP may be transmitted to the central processor CP through ISOSPI (isolated Serial Peripheral Interface) communication.

The central processor CP may generate a control operation command or a protection operation command based on the state data of the battery cells C transmitted from the monitoring processor MP, and may feed the command back to the monitoring processor MP, thereby causing the monitoring processor MP to perform the control operation and protection operation described above. The central processor CP that performs such functions may correspond to a micro controller unit (MCU) of the BMS. The central processor CP may communicate with an upper-level controller (e.g., an electronic control unit (ECU) of a vehicle equipped with the battery pack P) through a communication protocol, such as a controller area network (CAN), real-time clock (RTC), or universal asynchronous receiver-transmitter (UART).

The shunt resistor SR may be connected to a path (corresponding to a charge/discharge path) from a positive terminal P+ of the battery pack P to a negative terminal P- of the battery pack P through the battery cells C, and may function as a resistance element for detecting overcurrent flowing in the battery cells C.

The charge/discharge switch SW may correspond to a metal-oxide-semiconductor field-effect transistor (MOSFET) or relay that controls the current flow on the charge/discharge path described above, and the switch driver SDRV may correspond to a gate driver that controls an on/off operation of the charge/discharge switch SW under the control of the central processor CP.

An entity that performs the operation of detecting overcurrent through the shunt resistor SR, and the operation of controlling the switch driver SDRV to control the on/off operation of the charge/discharge switch SW if overcurrent is detected, may correspond to the monitoring processor MP or may correspond to the central processor CP. FIG. 5 shows an example in which the central processor CP is the entity performing the above operation, and in this case, the central processor CP may detect a state in which overcurrent flows in the battery cells C through the shunt resistor SR, and may control the switch driver SDRV to turn off the charge/discharge switch SW, thereby reducing or preventing damage to the battery cells C due to overcurrent.

The regulator REG may regulate a voltage level at a top node B+ of the plurality of battery cells C to a level corresponding to an operating voltage of the central processor CP, and an operating voltage VCC of the central processor CP may be generated by the regulator REG. The regulator REG may be implemented as a DC/DC converter that converts a voltage at the top node B+ of the plurality of battery cells C to the operating voltage of the central processor CP.

If the battery cell or battery pack is deformed due to an external impact, if metallic foreign substances are introduced into the battery cell during a manufacturing process of the battery cell, or if lithium is precipitated by the electrochemical reaction, the lifetime of the battery cell may be reduced. Furthermore, an internal short circuit may occur in the battery cell, thereby causing safety problems, such as thermal runaway. In view of the fact that the voltage behavior of the battery cell in which an abnormality has occurred is unstable, as shown by a tendency for the voltage to diverge, one or more embodiments proposes quantitative criteria for detecting an abnormal battery cell (e.g., a battery cell in which deformation has occurred due to an external impact, in which metallic foreign substances have been introduced, or in which lithium has been precipitated), which are described below.

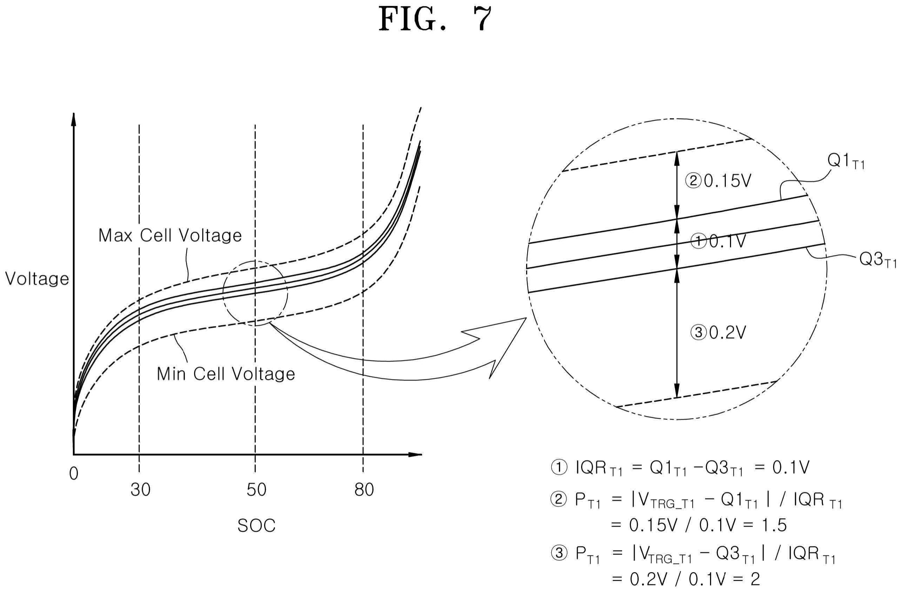

FIG. 6 is a block diagram illustrating a battery abnormality detection apparatus according to one or more embodiments of the present disclosure, and FIG. 7 is a view illustrating an example of a cell voltage and an interquartile range of the battery cell (e.g., a range within which the middle 50% of a data set falls) according to one or more embodiments of the present disclosure.

Referring to FIG. 6, the battery abnormality detection apparatus of one or more embodiments may include a memory 100 and a processor 200, and may be implemented as the BMS described above, or may function as part of the BMS. The BMS may comprise or be the battery abnormality detection apparatus or vice versa.

The memory 100 may store one or more instructions to be executed by the processor 200 to be described below. The memory 100 may be implemented as a volatile storage medium and/or nonvolatile storage medium, for example, a read-only memory (ROM) and/or random-access memory (RAM). The memory 100 may also be implemented by being integrated within the processor 200.

The processor 200 may be configured to detect an abnormality of a target battery cell based on a cell voltage of the target battery cell. The target battery cell may be one battery cell among a plurality of battery cells, and may be indicated in this specification to refer to a battery cell that is a target of abnormality detection. Because the target battery cell corresponds to a battery cell that is a target of abnormality detection, the processor 200 may be configured to specify a battery cell having a cell voltage that is outside the interquartile range of cell voltages of the plurality of battery cells as a target battery cell. The processor 200 may be implemented as a central processing unit (CPU) or a system on a chip (SoC), and may control multiple hardware or software components connected to the processor 200 by running an operating system or application, and may perform various data processing and calculations. The processor 200 may be configured to execute one or more instructions stored in the memory 100, and may store execution result data in the memory 100. The processor 200 may be configured to include the monitoring processor MP (e.g., AFE IC) and the central processor (e.g., MCU) described above.

The processor 200 may determine a size of an interquartile range IQR of a plurality of cell voltages obtained for the plurality of battery cells, may analyze the relative behavior of a cell voltage of a target battery cell with respect to the plurality of cell voltages based on the may mean a change in position of the target cell voltage with respect to the plurality of cell voltage), and may detect an abnormality of the target battery cell. The relative behavior of the cell voltage of the target battery cell with respect to the plurality of cell voltages may mean a change in position of the target cell voltage with respect to the plurality of cell voltages, or a deviation of the target cell voltage from the plurality of cell voltages (for convenience of notation, "the relative behavior of the cell voltage of the target battery cell with respect to the plurality of cell voltages" is hereinafter expressed as "the relative behavior of the cell voltage of the target battery cell").

Based on a current time point Tn, the processor 200 may analyze the relative behavior of the cell voltage of the target battery cell by obtaining a target cell voltage $V_{TRG\_Tn}$ of the target battery cell, by determining a size of an interquartile range $IQR_{Tn}$, and by determining a parameter $P_{Tn}$ indicating a relative position of the target cell voltage $V_{TRG\_Tn}$ with respect to the plurality of cell voltages based on the target cell voltage $V_{TRG\_Tn}$ and the size of the interquartile range $IQR_{Tn}$.

For example, the processor 200, at a first time point T1, may obtain a target cell voltage $V_{TRG\_T1}$ of the target battery cell, may determine a size of an interquartile range $IQR_{T1}$, and may determine a first parameter $P_{T1}$ indicating a relative position of the target cell voltage $V_{TRG\_T1}$ with respect to the plurality of cell voltages based on the target cell voltage $V_{TRG\_T1}$ and the size of the interquartile range $IQR_{T1}$.

In one or more embodiments, the processor 200, at a second time point T2 following the first time point T1, may obtain a target cell voltage $V_{TRG\_T2}$ of the target battery cell, may determine a size of an interquartile range $IQR_{T2}$, and may determine a second parameter $P_{T2}$ indicating a relative position of the target cell voltage $V_{TRG\_T2}$ with respect to the plurality of cell voltages based on the target cell voltage $V_{TRG\_T2}$ and the size of the interquartile range $IQR_{T2}$.

The first and second time points T1 and T2, at which the first and second parameters $P_{T1}$ and $P_{T2}$ are determined, may be determined according to the same state-of-charge SOC condition in which an overall SOC of the plurality of battery cells (e.g., a SOC of the battery pack) has a reference SOC (e.g., predefined reference SOC). The overall SOC of the plurality of battery cells at the first and second time points T1 and T2 is equal to the reference SOC. In one or more embodiments, the first parameter $P_{T1}$ determined at the first time point T1 and the second parameter $P_{T2}$ determined at the second time point T2 assume the same battery pack state. The reference SOC may be predefined in the memory 100 as a corresponding SOC depending on a designer's intention (e.g. about 30%, about 50%, or about 80%).

At the first time point T1, the processor 200 may calculate a difference between a first quartile or a third interquartile of the plurality of cell voltages and the target cell voltage $V_{TRG\_T1}$, and may determine the first parameter $P_{T1}$ by a ratio of the calculated difference and the size of the interquartile range $IQR_{T1}$.

The size of the interquartile range $IQR_{T1}$ may be determined according to Equation 1 below.

[Equation 1]

$$IQR_{T1} = Q3_{T1} - Q1_{T1}$$

In Equation 1, $Q3_{T4}$ is a third quartile (e.g., 75th percentile) of a plurality of cell voltages at the first time point T1, and $Q1_{T1}$ is a first quartile (e.g., 25th percentile) of the plurality of cell voltages at the first time point T1.

If the target cell voltage $V_{TRG\_T1}$ is greater than the first quartile of the plurality of cell voltages, the processor 200 may determine the first parameter $P_{T1}$ by a ratio of the difference between the target cell voltage $V_{TRG\_T1}$ and the first quartile of the plurality of cell voltages and the size of the interquartile range $IQR_{T1}$. If the target cell voltage $V_{TRG\_T1}$ is less than the third quartile of the plurality of cell voltages, the processor 200 may determine the first parameter $P_{T1}$ by a ratio of the difference between the target cell voltage $V_{TRG\_T1}$ and the third quartile of the plurality of cell voltages and the size of the interquartile range $IQR_{T1}$.

In one or more embodiments, the first parameter $P_{T1}$ may be determined according to Equation 2-1 and/or Equation 2-2 below.

[Equation 2-1]

$$P_{T1} = |V_{TRG\_T1} - Q1_{T1}| / IQR_{T1} \text{ (if } V_{TRG\_T1} > Q1_{T1})$$

[Equation 2-2]

$$P_{T1} = |V_{TRG\_T1} - Q3_{T1}| / IQR_{T1} \text{ (if } V_{TRG\_T1} < Q3_{T1})$$

Because the first parameter $P_{T1}$, which may be determined by Equations 2-1 and 2-2, may be based on the size of the interquartile range (e.g., based on the upper cell voltage at an upper limit of the interquartile range IQR or the lower cell voltage at a lower limit of the interquartile range, and based on the size of the interquartile range), which is a measure of statistical dispersion, the first parameter $P_{T1}$ represents the relative position of the target cell voltage $V_{TRG\_T1}$ with respect to the plurality of cell voltages at the first time point T1.

Referring to FIG. 7 (e.g., the reference SOC = 50%), if the target battery cell corresponds to a battery cell having a max cell voltage, the first parameter $P_{T1}$ is determined to be 1.5 according to Equation 2-1. If the target battery cell corresponds to a battery cell having a min cell voltage, the first parameter $P_{T1}$ is determined to be 2 according to Equation 2-2.

Next, at the second time point T2, the processor 200 may calculate a difference between the first quartile or the third quartile of the plurality of cell voltages and the target cell voltage $V_{TRG\_T2}$, and may determine the second parameter $P_{T2}$ by a ratio of the calculated difference and the size of the interquartile range $IQR_{T2}$.

The size of the interquartile range $IQR_{T2}$ may be determined according to Equation 3 below.

[Equation 3]

$$IQR_{T2} = Q3_{T2} - Q1_{T2}$$

In Equation 3, $Q3_{T2}$ is a third quartile of a plurality of cell voltages at the second time point T2, and $Q1_{T2}$ is a first quartile of the plurality of cell voltages at the second time point T2.

If the target cell voltage $V_{TRG\_T2}$ is greater than the first quartile of the plurality of cell voltages, the processor 200 may determine the second parameter $P_{T2}$ by a ratio of the difference between the target cell voltage $V_{TRG\_T2}$ and the first quartile of the plurality of cell voltages and the size of the interquartile range $IQR_{T2}$. If the target cell voltage $V_{TRG\_T2}$ is less than the third quartile of the plurality of cell voltages, the processor 200 may determine the second parameter $P_{T2}$ by a ratio of the difference between the target cell voltage $V_{TRG\_T2}$ and the third quartile of the plurality of cell voltages and the size of the interquartile range $IQR_{T2}$.

In one or more embodiments, the second parameter $P_{T2}$ may be determined according to Equation 4-1 and/or Equation 4-2 below.

[Equation 4-1]

$$P_{T2} = |V_{TRG\_T2} - Q1_{T2}| / IQR_{T2} \text{ (if } V_{TRG\_T2} > Q1_{T2})$$

[Equation 4-2]

$$P_{T2} = |V_{TRG\_T2} - Q3_{T2}| / IQR_{T2} \text{ (if } V_{TRG\_T2} < Q3_{T2})$$

Because the second parameter $P_{T2}$ determined by Equations 4-1 and 4-2 is based on the size of the interquartile range, which is a measure of statistical dispersion, it represents the relative position of the target cell voltage $V_{TRG\_T2}$ with respect to the plurality of cell voltages at the second time point T2.

If the first parameter $P_{T1}$ and the second parameter $P_{T2}$ are determined, the processor 200 may analyze the relative behavior of the cell voltage of the target battery cell by using a difference between the first parameter $P_{T1}$ and the second parameter $P_{T2}$.

For example, the processor 200 may determine a first behavior parameter $\triangle P1$ indicating the relative behavior of the cell voltage of the target battery cell in a time interval from the first time point T1 to the second time point T2 by using the difference between the first parameter $P_{T1}$ and the second parameter $P_{T2}$, and may detect an abnormality of the target battery cell by comparing the determined first behavior parameter $\triangle P1$ with a reference range (e.g., predefined reference range). The reference range is a reference value for determining whether the cell voltage of the target battery cell is diverging, and may be predefined in the memory 100 in consideration of the designer's intention and the specifications of the battery pack.

The first behavior parameter $\triangle P1$ may be determined according to Equation 5 below.

[Equation 5]

$$\triangle P1 = (P_{T1} - P_{T2}) / Factor_{Tcompen1}$$

In Equation 5, $Factor_{Tcompen1}$ is a first time compensation factor (described below).

The first behavior parameter $\triangle P1$ having a positive or negative value that is outside the reference range respectively means that the cell voltage of the target battery cell is diverging in a positive or negative direction in the time interval from the first time point T1 to the second time point T2. Therefore, in this case, the processor 200 may determine that the target battery cell is abnormal.

To more accurately determine the cell voltage divergence tendency of the target battery cell, the processor 200 may also extend a target time interval for detecting the abnormality of the target battery cell.

For example, the processor 200, at a third time point T3 following the second time point T2, may obtain a target cell voltage $V_{TRG\_T3}$ of the target battery cell, may determine a size of an interquartile range $IQR_{T3}$, and may determine a third parameter $P_{T3}$ indicating a relative position of the target cell voltage $V_{TRG\_T3}$ with respect to the plurality of cell voltages based on the target cell voltage $V_{TRC\_T3}$ and the size of the interquartile range $IQR_{T3}$. A SOC of the battery pack at the third time point T3 also has the same value as the reference SOC described above.

At the third time point T3, the processor 200 may calculate a difference between the first quartile or the third quartile of the plurality of cell voltages and the target cell voltage $V_{TRG\_T3}$, and may determine the third parameter $P_{T3}$ by a ratio of the calculated difference and the size of the interquartile range $IQR_{T3}$.

The size of the interquartile range $IQR_{T3}$ may be determined according to Equation 3 below.

[Equation 6]

$$IQR_{T3} = Q3_{T3} - Q1_{T3}$$

In Equation 6, $Q3_{T3}$ is a third quartile of the plurality of cell voltages at the third time point T3, and $Q1_{T3}$ is a first quartile of the plurality of cell voltages at the third time point T3.

If the target cell voltage $V_{TRG\_T3}$ is greater than the first quartile of the plurality of cell voltages, the processor 200 may determine the third parameter $P_{T3}$ by a ratio of the difference between the target cell voltage $V_{TRG\_T3}$ and the first quartile of the plurality of cell voltages and the size of the interquartile range $IQR_{T3}$. If the target cell voltage $V_{TRG\_T3}$ is less than the third quartile of the plurality of cell voltages, the processor 200 may determine the third parameter $P_{T3}$ by a ratio of the difference between the target cell voltage $V_{TRG\_T3}$ and the third quartile of the plurality of cell voltages and the size of the interquartile range $IQR_{T3}$.

In one or more embodiments, the third parameter $P_{T3}$ may be determined according to Equation 7-1 and/or Equation 7-2 below.

[Equation 7-1]

$$P_{T3} = |V_{TRG\_T3} - Q1_{T3}| / IQR_{T3} \ (if \ V_{TRG\_T3} > Q1_{T3})$$

[Equation 7-2]

$$P_{T3} = |V_{TRG\_T3} - Q3_{T3}| / IQR_{T3} \ (if \ V_{TRG\_T3} < Q3_{T3})$$

Because the third parameter $P_{T3}$ determined by Equations 7-1 and 7-2 is based on the size of the interquartile range, which is a measure of statistical dispersion, it represents the relative position of the target cell voltage $V_{TRG\_T3}$ with respect to the plurality of cell voltages at the third time point T3.

If the third parameter $P_{T3}$ is determined, the processor 200 may determine a second behavior parameter $\triangle P2$ indicating the relative behavior of the cell voltage of the target battery cell in a time interval from the second time point T2 to the third time point T3 by using a difference between the second parameter $P_{T2}$ and the third parameter $P_{T3}$. The second

behavior parameter $\triangle P2$ may be determined according to Equation 8 below.

[Equation 8]

$$\triangle P2 = (P_{T3} - P_{T2}) / Factor_{Tcompen2}$$

In Equation 8, $Factor_{Tcompen2}$ is a second time compensation factor (described below).

If the second behavior parameter $\triangle P2$ is determined, the processor 200 may detect an abnormality of the target battery cell by comparing the first behavior parameter $\triangle P1$ and the second behavior parameter $\triangle P2$ with the reference range described above. If the first behavior parameter $\triangle P1$ and the second behavior parameter $\triangle P2$ have a positive or negative value that is outside the reference range, it means that the cell voltage of the target battery cell is diverging in a positive direction or a negative direction (respectively) in a time interval from the first time point T1 to the third time point T3. Therefore, in this case, the processor 200 may determine that the target battery cell is abnormal. The processor 200 may detect the abnormality of the target battery cell by comparing the first behavior parameter $\triangle P1$ to an Nth behavior parameter $\triangle PN$ with the reference range, and N may be designed as a corresponding value according to the designer's intention (e.g., 5 or about 5).

Tables 1 and 2 below show examples for describing a process of detecting an abnormality of the target battery cell. Table 1 corresponds to a case in which the target battery cell is Cell 1, and Table 2 corresponds to a case in which the target battery cell is Cell 2. The first and second time compensation factors $Factor_{Tcompen1}$ and $Factor_{Tcompen2}$ are assumed to be 1, and the reference range is assumed to range from about -0.05 to about 0.05.

[Table 1]

| Cell 1 | | | |
|---|---|---|---|
| PT1 | PT2 | PT3 | PT4 |
| 1 | 1.1 | 1.2 | 1.3 |
| $\triangle P1 = 0.1$ | | | - |
| - | $\triangle P2 = 0.1$ | | - |
| - | - | $\triangle P3 = 0.1$ | |

[Table 2]

| Cell 2 | | | |
|---|---|---|---|
| PT1 | PT2 | PT3 | PT4 |

| | | | |
|---|---|---|---|
| 1 | 1 | 1 | 1 |
| $\triangle P1 = 0$ | | - | - |
| - | $\triangle P2 = 0$ | | - |
| - | - | $\triangle P3 = 0$ | |

In Table 1, the first to third behavior parameters $\triangle P1$ to $\triangle P3$ are maintained at a value of about 0.1, which exceeds the reference range, so that the processor 200 may determine that the cell voltage of the target battery cell (Cell 1) is diverging in a positive direction, and thus the target battery cell (Cell 1) may be determined to be abnormal.

In Table 2, the first to third behavior parameters $\triangle P1$ to $\triangle P3$ are maintained at a value of about 0, which is within the reference range, so that the processor 200 may determine that the cell voltage of the target battery cell (Cell 2) is in a stabilized state, and thus the target battery cell (Cell 2) may be determined to be normal.

In one or more embodiments, the first and second time compensation factors $Factor_{Tcompen1}$ and $Factor_{Tcompen2}$, applied to Equations 5 and 8, may function as factors to normalize the first behavior parameter $\triangle P1$ and the second behavior parameter $\triangle P2$ by compensating for a difference between a time length from the first time point T1 to the second time point T2 and a time length from the second time point T2 to the third time point T3. A time length $T_{length1}$ between the first time point T1 at which the SOC of the battery pack is set (e.g., formed) as the reference SOC, and the second time point T2 at which the SOC of the battery pack is set as the reference SOC again, which is after the first time point T1, may be different from a time length $T_{length2}$ between the second time point T2 and the third time point T3, at which the SOC of the battery pack is again set as the reference SOC, and which is after the second time point T2. The fact that the time lengths $T_{length1}$ and $T_{length2}$ are different means that the usage amount of the battery pack in each time interval is different, which means that even if the SOC of the battery pack at the second time point T2 and the third time point T3 is set as the same reference SOC and the same battery cell is monitored, there may be a variation in the current, voltage, and temperature of the battery cell in each time interval.

In one or more embodiments, the processor 200 may determine the first behavior parameter $\triangle P1$ by dividing the difference between the first parameter PT1 and the second parameter PT2 by the first time compensation factor $Factor_{Tcompen1}$, and similarly, the processor 200 may determine the second behavior parameter $\triangle P2$ by dividing the difference between the second parameter $P_{T2}$ and the third parameter $P_{T3}$ by the second time compensation factor $Factor_{Tcompen2}$. The processor 200 may determine the first time compensation factor $Factor_{Tcompen1}$ for determining the first behavior parameter $\triangle P1$ based on a throughput capacity, and the driving distance and driving time of the vehicle, which are factors determining the battery usage in the first time interval corresponding to the time length $T_{length1}$, and similarly, may determine the second time compensation factor $Factor_{Tcompen2}$ for determining the second behavior parameter $\triangle P2$ based on the throughput capacity, and the driving distance and driving time of the vehicle in the second time interval corresponding to the time length $T_{length2}$. The algorithm for determining the first and second time compensation factors $Factor_{Tcompen1}$ and $Factor_{Tcompen2}$ may be designed by the designer, and may be predefined in the memory 100.

In one or more embodiments, the processor 200 may determine the size of the interquartile range $IQR_{Tn}$ as the above-mentioned reference value if the size of the interquartile range $IQR_{Tn}$ determined at the current time point Tn (e.g., the first time point T1, the second time point T2, or the third time point T3) is less than or equal to the reference value.

In a normal state in which no abnormality occurs in the plurality of battery cells, the dispersion between the cell voltages of each battery cell converges to a value of about 0, and the size of the interquartile range $IQR_{Tn}$ also converges to a value of about 0. In this case, the first parameter $P_{T1}$ according to Equation 2 and the second parameter $P_{T2}$ according to Equation 4 may have abnormally large values. If a difference between the size of the interquartile range $IQR_{T1}$ determined at the first time point T1 and the size of the interquartile range $IQR_{T2}$ determined at the second time point T2 is relatively very large, the difference between the first parameter $P_{T1}$ and the second parameter $P_{T2}$ will also have a relatively very large value, and thus the reliability of the first behavior parameter $\triangle P1$ determined by the difference may be reduced (the same may apply to the second behavior parameter $\triangle P2$).

To reduce or prevent the likelihood of a situation in which the reliability of the behavior parameters is reduced, a minimum value (e.g., a lower limit) of the size of the interquartile range $IQR_{Tn}$ may be suitably defined. In one or more embodiments, the processor 200 may determine the size of the interquartile range $IQR_{Tn}$ as the above-mentioned reference value if the size of the interquartile range $IQR_{Tn}$ is less than or equal to the reference value, and the reference value may be designed as a corresponding value according to the designer's intention, and may be predefined in the memory 100.

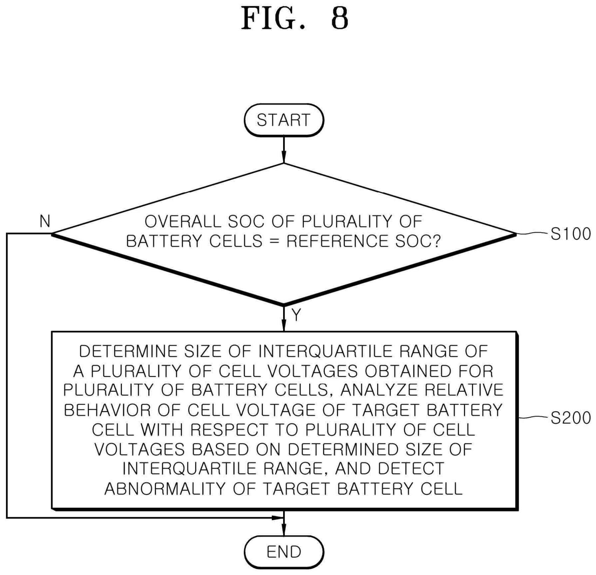

FIG. 8 is a flow chart illustrating a battery abnormality detection method according to one or more embodiments of the present disclosure, and the battery abnormality detection method of one or more embodiments is described with reference to FIG. 8.

First, the processor 200 may determine whether an overall SOC of a plurality of battery cells is set as a reference SOC (e.g., predefined reference SOC) (S100).

If it is determined in operation S100 that the overall SOC of the plurality of battery cells is set as the reference SOC, the processor 200 may determine a size of an interquartile range of the plurality of cell voltages measured for the plurality of battery cells, and may analyze the relative behavior of a cell voltage of a target battery cell with respect to the plurality of cell voltages based on the determined size of the interquartile range to detect an abnormality of the target battery cell (S200). Operation S200 is repeated each time the determination result of operation S100 is determined to be positive.

In operation S200, the processor 200 may analyze the relative behavior of the cell voltage of the target battery cell by obtaining a target cell voltage $V_{TRG\_T}$, of the target battery cell at a current time point Tn, by determining a size of an interquartile range $IQR_{Tn}$, and by determining a parameter $P_{Tn}$ indicating a relative position of the target cell voltage $V_{TRG\_Tn}$ with respect to the plurality of cell voltages based on the target cell voltage $V_{TRG\_Tn}$ and the size of the interquartile range $IQR_{Tn}$.

In operation S200, the processor 200 may obtain a target cell voltage $V_{TRG\_T1}$ of the target battery cell at a first time point T1, may determine a size of an interquartile range $IQR_{T1}$, and may determine a first parameter $P_{T1}$ indicating the relative position of the target cell voltage $V_{TRG\_T1}$ with respect to the plurality of cell voltages based on the target cell voltage $V_{TRG\_T1}$ and the size of the interquartile range $IQR_{T1}$. In one or more embodiments, the processor 200 may obtain a target cell voltage $V_{TRG\_T2}$ of the target battery cell at a second time point T2 subsequent to the first time point T1, may determine a size of an interquartile range $IQR_{T2}$, and may determine a second parameter $P_{T2}$ indicating a relative position of the target cell voltage $V_{TRG\_T2}$ with respect to the plurality of cell voltages based on the target cell voltage $V_{TRG\_T2}$ and the size of the interquartile range $IQR_{T2}$. Also, the processor 200 may analyze the relative behavior of the cell voltage of the target battery cell by using a difference between the first parameter $P_{T1}$ and the second parameter $P_{T2}$.

In operation S200, the processor 200 may calculate, at the first time point T1, a difference between a first quartile or a third quartile of the plurality of cell voltages and the target cell voltage $V_{TRG\_T1}$, and may determine the first parameter $P_{T1}$ by a ratio of the calculated difference and the size of the interquartile range $IQR_{T1}$. For example, the processor 200 may determine the first parameter $P_{T1}$ by a ratio of the difference between the target cell voltage $V_{TRG\_T1}$ and the first quartile of the plurality of cell voltages and the size of the interquartile range $IQR_{T1}$ if the target cell voltage $V_{TRG\_T1}$ is greater than the first quartile of the plurality of cell voltages, and may determine the first parameter $P_{T1}$ by a ratio of the difference between the target cell voltage $V_{TRG\_T1}$ and the first quartile of the plurality of cell voltages and the size of the interquartile range $IQR_{T1}$ if the target cell voltage $V_{TRG\_T1}$ is less than the third quartile of the plurality of cell voltages.

In operation S200, the processor 200 may calculate, at the second time point T2, a difference between the first quartile or the third quartile of the plurality of cell voltages and the target cell voltage $V_{TRG\_T2}$, and may determine the second parameter $P_{T2}$ by a ratio of the calculated difference and the size of the interquartile range $IQR_{T2}$. For example, the processor 200 may determine the second parameter $P_{T2}$ by a ratio of the difference between the target cell voltage $V_{TRG\_T2}$ and the first quartile of the plurality of cell voltages and the size of the interquartile range $IQR_{T2}$ if the target cell voltage $V_{TRG\_T2}$ is greater than the first quartile of the plurality of cell voltages, and may determine the second parameter $P_{T2}$ by a ratio of the difference between the target cell voltage $V_{TRG\_T2}$ and the first quartile of the plurality of cell voltages and the size of the interquartile range $IQR_{T2}$ if the target cell voltage $V_{TRG\_T2}$ is less than the third quartile of the plurality of cell voltages..

In operation S200, the processor 200 may determine a first behavior parameter $\triangle P1$ indicating the relative behavior of the cell voltage of the target battery cell in a time interval from the first time point T1 to the second time point T2 by using the difference between the first parameter $P_{T1}$ and the second parameter $P_{T2}$, and may detect an abnormality of the target battery cell by comparing the determined first behavior parameter $\triangle P1$ with a reference range (e.g., a predefined reference range).

The processor 200 may also extend the time interval for detecting the abnormality of the target battery cell. In this case, the processor 200 may obtain a target cell voltage $V_{TRG\_T3}$ of the target battery cell at a third time point T3 following the second time point T2, may determine a size of an interquartile range $IQR_{T3}$, and may determine a third parameter $P_{T3}$ indicating a relative position of the target cell voltage $V_{TRG\_T3}$ with respect to the plurality of cell voltages based on the target cell voltage $V_{TRG\_T3}$ and the size of the interquartile range $IQR_{T3}$. Then, the processor 200 may determine a second behavior parameter $\triangle P2$ indicating the relative behavior of the cell voltage of the target battery cell in a time interval from the second time point T2 to the third time point T3 by using the difference between the second parameter $P_{T2}$ and the third parameter $P_{T3}$. Also, the processor 200 may detect an abnormality of the target battery cell by comparing the first behavior parameter $\triangle P1$ and the second behavior parameter $\triangle P2$ with a reference range.

In operation S200, the processor 200 may determine the first behavior parameter $\triangle P1$ by dividing the difference between the first parameter $P_{T1}$ and the second parameter $P_{T2}$ by a first time compensation factor $Factor_{Tcompen1}$, and may determine the second behavior parameter $\triangle P2$ by dividing the difference between the second parameter $P_{T2}$ and the third parameter $P_{T3}$ by a second time compensation factor $Factor_{Tcompen2}$. The first and second time compensation factors $Factor_{Tcompen1}$ and $Factor_{Tcompen2}$ function to normalize the first behavior parameter $\triangle P1$ and the second behavior parameter $\triangle P2$ by compensating for a difference between a time length from the first time point T1 to the second time point T2 and a time length from the second time point T2 to the third time point T3.

In one or more embodiments, in operation S200, the processor 200 may also determine the size of the interquartile range $IQR_{Tn}$ as a reference value if the size of the interquartile range $IQR_{Tn}$ determined at the current time point Tn is less than or equal to the reference value.

According to the present disclosure, the size of the interquartile range of the plurality of cell voltages obtained for the plurality of battery cells may be determined, and the relative behavior of the cell voltage of the target battery cell with respect to the plurality of cell voltages may be analyzed based on the determined size of the interquartile range to detect an abnormality of the target battery cell, thereby enabling an abnormal battery cell to be accurately detected in advance of damage.

The implementations described in the present disclosure may be implemented as, for example, a method or process, a device, a software program, a data stream or a signal. Even if discussed only in the context of a single form of implementation (e.g., discussed only as a method), the implementation of the discussed aspect may also be implemented in other forms (e.g., as a device or a program). The device may be implemented with suitable hardware, software and firmware, etc. The method may be implemented in a device, such as a processor, which generally refers to a processing device including, for example, a computer, a microprocessor, an integrated circuit or a programmable logic device. The processor also includes communication devices, such as computers, cell phones, personal digital assistants ("PDAs") and other devices that facilitate communication of information between end-users.

According to the present disclosure, a configuration is adopted for detecting an abnormality of a target battery cell by determining a size of an interquartile range of a plurality of cell voltages obtained for a plurality of battery cells, and analyzing the relative behavior of a cell voltage of the target battery cell with respect to the plurality of cell voltages based on the determined size of the interquartile range, thereby enabling an abnormal battery cell to be accurately detected in advance.

However, aspects that can be achieved through the present disclosure are not limited to the above-described aspects, and other aspects that are not described may be clearly understood by those skilled in the art from the detailed descriptions.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure and the claims, below.

**Claims**

1. A battery abnormality detection apparatus comprising:

   a memory (100) configured to store instructions; and [0089]
   a processor (200) that, when executing the instructions, causes the battery abnormality detection apparatus to:

   detect an abnormality of a target battery cell (C) of battery cells (10a, 10b, C) based on a cell voltage ($V_{TRG\_tn}$) of the target battery cell (C);
   determine a size of an interquartile range ($IQR_{Tn}$) of cell voltages for the battery cells (10a, 10b, C); and
   analyze a relative behavior of the cell voltage ($V_{TRG\_tn}$) of the target battery cell (C) with respect to the cell voltages for the battery cells (10a, 10b, C) based on the size of the interquartile range ($IQR_{Tn}$).

2. The battery abnormality detection apparatus as claimed in claim 1, wherein the processor (200) is configured to analyze the relative behavior at a current time point (Tn) by:

   obtaining the target cell voltage ($V_{TRG\_Tn}$) of the target battery cell (C);
   determining the size of the interquartile range ($IQR_{Tn}$); and
   determining a parameter ($P_{Tn}$) indicating a relative position of the target cell voltage ($V_{TRG\_Tn}$) with respect to the cell voltages based on the target cell voltage ($V_{TRG\_Tn}$) and the size of the interquartile range ($IQR_{Tn}$).

3. The battery abnormality detection apparatus as claimed in claim 2, wherein the processor (200):

   at a first time point (T1), is configured to obtain a first target cell voltage ($V_{TRG\_T1}$) of the target battery cell (C), is configured to determine a first size of a first interquartile range ($IQR_{T1}$), and is configured to determine a first parameter ($P_{T1}$) indicating a first relative position of the first target cell voltage ($V_{TRG\_T1}$) with respect to the cell voltages based on the first target cell voltage ($V_{TRG\_T1}$) and the first size of the first interquartile range ($IQR_{T1}$);
   at a second time point (T2) following the first time point (T1), is configured to obtain a second target cell voltage ($V_{TRG\_T2}$) of the target battery cell (C), is configured to determine a second size of a second interquartile range ($IQR_{T2}$), and is configured to determine a second parameter ($P_{T2}$) indicating a second relative position of the second target cell voltage ($V_{TRG\_T2}$) with respect to the cell voltages based on the second target cell voltage ($V_{TRG\_T2}$) and the second size of the second interquartile range ($IQR_{T2}$); and
   is configured to analyze the relative behavior using a difference between the first parameter ($P_{T1}$) and the second parameter ($P_{T2}$).

4. The battery abnormality detection apparatus as claimed in claim 3, wherein the processor (200):

   at the first time point (T1), is configured to calculate a first difference between a first quartile or a third quartile of the cell voltages of the first interquartile range ($IQR_{T1}$) and the first target cell voltage ($V_{TRG\_T1}$), and is configured to determine the first parameter ($P_{T1}$) by a first ratio of the first difference and the first size of the first interquartile range ($IQR_{T1}$); and
   at the second time point (T2), is configured to calculate a second difference between a first quartile or a third quartile of the cell voltages of the second interquartile range ($IQR_{T2}$) and the second target cell voltage ($V_{TRG\_T2}$), and is configured to determine the second parameter ($P_{T2}$) by a second ratio of the second difference and the second size of the second interquartile range ($IQR_{T2}$).

5. The battery abnormality detection apparatus as claimed in claim 4, wherein the first difference is between the first target cell voltage ($V_{TRG\_T1}$) and the first quartile of the cell voltages of the first interquartile range ($IQR_{T1}$) when the first target cell voltage ($V_{TRG\_T1}$) is greater than the first quartile, and is between the first target cell voltage ($V_{TRG\_T1}$) and the third quartile of the cell voltages of the first interquartile range ($IQR_{T1}$) when the first target cell voltage ($V_{TRG\_T1}$) is less than the third quartile, and

wherein the second difference is between the second target cell voltage ($V_{TRG\_T2}$) and the first quartile of the cell voltages of the second interquartile range ($IQR_{T2}$) when the second target cell voltage ($V_{TRG\_T2}$) is greater than the first quartile, and is between the second target cell voltage ($V_{TRG\_T2}$) and the third quartile of the cell voltages of the second interquartile range ($IQR_{T2}$) when the second target cell voltage ($V_{TRG\_T2}$) is less than the third quartile.

6.  The battery abnormality detection apparatus as claimed in any of claims 3 to 5, wherein the processor (200) is configured to determine a first behavior parameter ($\triangle P1$) indicating the relative behavior in a first time interval from the first time point (T1) to the second time point (T2) by using the difference between the first parameter ($P_{T1}$) and the second parameter ($P_{T2}$), and is configured to detect the abnormality of the target battery cell by comparing the first behavior parameter ($\triangle P1$) with a reference range.

7.  The battery abnormality detection apparatus as claimed in claim 6, wherein the processor (200):

    at a third time point (T3) following the second time point (T2), is configured to obtain a third target cell voltage ($V_{TRC\_T3}$) of the target battery cell, is configured to determine a third size of a third interquartile range ($IQR_{T3}$), and is configured to determine a third parameter ($P_{T3}$) indicating a third relative position of the third target cell voltage ($V_{TRG\_T3}$) with respect to the cell voltages based on the third target cell voltage ($V_{TRC\_T3}$) and the third size;
    is configured to determine a second behavior parameter ($\triangle P2$) indicating the relative behavior in a second time interval from the second time point (T2) to the third time point (T3) by using a difference between the second parameter ($P_{T2}$) and the third parameter ($P_{T3}$); and
    is configured to detect the abnormality of the target battery cell by comparing the first behavior parameter ($\triangle P1$) and the second behavior parameter ($\triangle P2$) with the reference range.

8.  The battery abnormality detection apparatus as claimed in claim 7, wherein the first time point (T1), the second time point (T2), and the third time point (T3) are determined according to a same state-of-charge, SOC, condition in which an overall SOC of the battery cells has a reference SOC.

9.  The battery abnormality detection apparatus as claimed in claim 7 or 8, wherein the processor (200):

    is configured to determine the first behavior parameter ($\triangle P1$) by dividing the difference between the first parameter ($P_{T1}$) and the second parameter ($P_{T2}$) by a first time compensation factor ($Factor_{Tcompen1}$); and
    is configured to determine the second behavior parameter ($\triangle P2$) by dividing the difference between the second parameter ($P_{T2}$) and the third parameter ($P_{T3}$) by a second time compensation factor ($Factor_{Tcompen2}$), and wherein the first time compensation factor ($Factor_{Tcompen1}$) and the second time compensation factor ($Factor_{Tcompen2}$) are for normalizing the first behavior parameter ($\triangle P1$) and the second behavior parameter ($\triangle P2$) by compensating for a difference between a first time length between the first time point (T1) and the second time point (T2) and a second time length between the second time point (T2) and the third time point (T3).

10. The battery abnormality detection apparatus as claimed in any of claims 2 to 9, wherein the processor (200), when the size of the interquartile range ($IQR_{Tn}$) at the current time point (Tn) is less than or equal to a reference value, is configured to determine the size of the interquartile range ($IQR_{Tn}$) as the reference value.

11. A battery pack (P) comprising:

    a battery comprising battery cells (10a, 10b C); and
    a processor (200) configured to detect an abnormality of a target battery cell (C) of the battery cells (10a, 10b C) based on a cell voltage ($V_{TRG\_tn}$) of the target battery cell (C), configured to determine a size of an interquartile range of cell voltages ($IQR_{Tn}$) of the battery cells (10a, 10b C), configured to analyze a relative behavior of the cell voltage ($V_{TRG\_tn}$) of the target battery cell (C) with respect to the cell voltages based on the size of the interquartile range ($IQR_{Tn}$), and configured to detect the abnormality of the target battery cell (C).

12. A battery abnormality detection method comprising:

    determining (S100), by a processor (200), whether an overall state-of-charge, SOC, of battery cells (10a, 10b, C) is equal to a reference SOC;

determining (S200), by the processor (200), a size of an interquartile range ($IQR_{Tn}$) of cell voltages of the battery cells (10a, 10b, C);

analyzing a relative behavior of a cell voltage ($V_{TRG\_tn}$) of a target battery cell (C) with respect to the cell voltages based on the size of the interquartile range ($IQR_{Tn}$); and

detecting an abnormality of the target battery cell (C) when the overall SOC of the battery cells is equal to the reference SOC.

13. The battery abnormality detection method as claimed in claim 12, wherein the detecting of the abnormality is repeatedly performed whenever the overall SOC of the battery cells (10a, 10b, C) is set as the reference SOC, and

wherein, in the detecting of the abnormality, the processor (200), at a current time point (Tn), is configured to analyze the relative behavior by obtaining a target cell voltage ($V_{TRG\_Tn}$) of the target battery cell (C), by determining the size of the interquartile range ($IQR_{Tn}$), and by determining a parameter ($P_{Tn}$) indicating a relative position of the target cell voltage ($V_{TRG\_Tn}$) with respect to the cell voltages based on the target cell voltage ($V_{TRG\_Tn}$) and the size of the interquartile range ($IQR_{Tn}$),

wherein, in the detecting of the abnormality, the processor (200):

at a first time point (T1), is configured to obtain a first target cell voltage ($V_{TRG\_T1}$) of the target battery cell (C), is configured to determine a first size of a first interquartile range ($IQR_{T1}$), and is configured to determine a first parameter ($P_{T1}$) indicating a first relative position of the first target cell voltage ($V_{TRG\_T1}$) with respect to the cell voltages based on the first target cell voltage ($V_{TRG\_T1}$) and the first size;

at a second time point (T2) following the first time point (T1), is configured to obtain a second target cell voltage ($V_{TRG\_T2}$) of the target battery cell, is configured to determine a second size of the second interquartile range ($IQR_{T2}$), and is configured to determine a second parameter ($P_{T2}$) indicating a second relative position of the second target cell voltage ($V_{TRG\_T2}$) with respect to the cell voltages based on the second target cell voltage ($V_{TRG\_T2}$) and the second size; and

is configured to analyze the relative behavior using a difference between the first parameter ($P_{T1}$) and the second parameter ($P_{T2}$).

14. The battery abnormality detection method as claimed in claim 13, wherein, in the detecting of the abnormality, the processor (200):

at the first time point (T1), is configured to calculate a first difference between a first quartile or a third quartile of the cell voltages of the first interquartile range ($IQR_{T1}$) and the first target cell voltage ($V_{TRG\_T1}$), and is configured to determine the first parameter ($P_{T1}$) by a first ratio of the first difference and the first size; and

at the second time point (T2), is configured to calculate a second difference between the first quartile or the third quartile of the cell voltages of the second interquartile range ($IQR_{T2}$) and the second target cell voltage ($V_{TRG\_T2}$), and is configured to determine the second parameter ($P_{T2}$) by a second ratio of the second difference and the second size,

wherein the first difference is between the first target cell voltage ($V_{TRG\_T1}$) and the first quartile of the first interquartile range ($IQR_{T1}$) when the first target cell voltage ($V_{TRG\_T1}$) is greater than the first quartile, and is between the first target cell voltage ($V_{TRG\_T1}$) and the third quartile of the first interquartile range ($IQR_{T1}$) when the first target cell voltage ($V_{TRG\_T1}$) is less than the third quartile, and

wherein the second difference is between the second target cell voltage ($V_{TRG\_T2}$) and the first quartile of the second interquartile range ($IQR_{T2}$) when the second target cell voltage ($V_{TRG\_T2}$) is greater than the first quartile, and is between the second target cell voltage ($V_{TRG\_T2}$) and the third quartile of the second interquartile range ($IQR_{T2}$) when the second target cell voltage ($V_{TRG\_T2}$) is less than the third quartile.

15. The battery abnormality detection method as claimed in claim 13 or 14, wherein in the detecting of the abnormality, the processor (200) is configured to determine a first behavior parameter ($\triangle P1$) indicating the relative behavior in a first time interval from the first time point (T1) to the second time point (T2) by using the difference between the first parameter ($P_{T1}$) and the second parameter ($P_{T2}$), and is configured to detect the abnormality of the target battery cell by comparing the first behavior parameter ($\triangle P1$) with a reference range,

wherein, in the detecting of the abnormality, the processor (200):

at a third time point (T3) following the second time point (T2), is configured to obtain a third target cell voltage ($V_{TRC\_T3}$) of the target battery cell, is configured to determine a third size of a third interquartile range ($IQR_{T3}$), and is configured to determine a third parameter ($P_{T3}$) indicating a third relative position of the third target cell voltage ($V_{TRG\_T3}$) with respect to the cell voltages based on the third target cell voltage ($V_{TRC\_T3}$) and the third size;
is configured to determine a second behavior parameter ($\triangle P2$) indicating the relative behavior in a second time interval from the second time point (T2) to the third time point (T3) by using a difference between the second parameter ($P_{T2}$) and the third parameter ($P_{T3}$); and
is configured to detect the abnormality of the target battery cell by comparing the first behavior parameter ($\triangle P1$) and the second behavior parameter ($\triangle P2$) with the reference range,
or wherein, in the detecting of the abnormality, the processor (200):

at a third time point (T3) following the second time point (T2), is configured to obtain a third target cell voltage ($V_{TRC\_T3}$) of the target battery cell, is configured to determine a third size of a third interquartile range ($IQR_{T3}$), and is configured to determine a third parameter ($P_{T3}$) indicating a third relative position of the third target cell voltage ($V_{TRG\_T3}$) with respect to the cell voltages based on the third target cell voltage ($V_{TRC\_T3}$) and the third size;
is configured to determine a second behavior parameter ($\triangle P2$) indicating the relative behavior in a second time interval from the second time point (T2) to the third time point (T3) by using a difference between the second parameter ($P_{T2}$) and the third parameter ($P_{T3}$); and
is configured to detect the abnormality of the target battery cell (C) by comparing the first behavior parameter ($\triangle P1$) and the second behavior parameter ($\triangle P2$) with the reference range.

# FIG. 1

# FIG. 2

FIG. 3

FIG. 4A

FIG. 4B

EP 4 768 957 A1

## FIG. 5

B+ ──────────────────────────────────── P+

REGULATOR ─REG

VCC │ CP

PWR

CENTRAL PROCESSOR

CAN

RTC

UART

C

MONITORING PROCESSOR

ISOSPI

MP

SDRV

SWITCH DRIVER

SW

B− ──────SR──────── P−

## FIG. 6

MEMORY ─ 100

PROCESSOR ─ 200

# FIG. 7

① $IQR_{T1} = Q1_{T1} - Q3_{T1} = 0.1V$

② $P_{T1} = |V_{TRG\_T1} - Q1_{T1}| / IQR_{T1}$
$= 0.15V / 0.1V = 1.5$

③ $P_{T1} = |V_{TRG\_T1} - Q3_{T1}| / IQR_{T1}$
$= 0.2V / 0.1V = 2$

EP 4 768 957 A1

# FIG. 8

START

OVERALL SOC OF PLURALITY OF
BATTERY CELLS = REFERENCE SOC? — S100

N

Y

DETERMINE SIZE OF INTERQUARTILE RANGE OF
A PLURALITY OF CELL VOLTAGES OBTAINED FOR
PLURALITY OF BATTERY CELLS, ANALYZE RELATIVE
BEHAVIOR OF CELL VOLTAGE OF TARGET BATTERY
CELL WITH RESPECT TO PLURALITY OF CELL
VOLTAGES BASED ON DETERMINED SIZE OF
INTERQUARTILE RANGE, AND DETECT
ABNORMALITY OF TARGET BATTERY CELL — S200

END

Europäisches
Patentamt

European
Patent Office

Office européen
des brevets

# EUROPEAN SEARCH REPORT

**Application Number**

EP 25 21 9306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 4 614 170 A1 (SAMSUNG SDI CO LTD [KR]) 10 September 2025 (2025-09-10) * figures 2,6 * * paragraph [0038] - paragraph [0039] * ----- | 1,11,12 | INV. G01R31/392 G01R31/396 |
| X | CN 117 706 387 A (FOSHAN SHUGANG TECH CO LTD) 15 March 2024 (2024-03-15) | 1,11,12 | |
| A | * figure 4 * * claims 1,3,10 * ----- | 3-9, 13-15 | |
| X | QIU YAN ET AL: "A Fault Diagnosis and Prognosis Method for Lithium-Ion Batteries Based on a Nonlinear Autoregressive Exogenous Neural Network and Boxplot", SYMMETRY, vol. 13, no. 9, 16 September 2021 (2021-09-16), page 1714, XP093392951, ISSN: 2073-8994, DOI: 10.3390/sym13091714 | 1,2, 10-12 | |
| A | * figures 9-11 * * table 4 * ----- | 3-9, 13-15 | **TECHNICAL FIELDS SEARCHED (IPC)** |
| X | LI FANG ET AL: "A Novel Method for Lithium-Ion Battery Fault Diagnosis of Electric Vehicle Based on Real-Time Voltage", WIRELESS COMMUNICATIONS AND MOBILE COMPUTING, vol. 2022, no. 1, 25 May 2022 (2022-05-25) , XP093392956, ISSN: 1530-8669, DOI: 10.1155/2022/7277446 | 1,11,12 | G01R |
| A | * figure 2 * ----- -/-- | 3-9, 13-15 | |

The present search report has been drawn up for all claims

| Place of search | Date of completion of the search | Examiner |
|---|---|---|
| The Hague | 30 April 2026 | Rambaud, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................................

& : member of the same patent family, corresponding document

EPO FORM 1503 03.82 (P04C01)

page 1 of 2

| | Europäisches Patentamt |
|---|---|
| | European Patent Office |
| | Office européen des brevets |

**EUROPEAN SEARCH REPORT**

**Application Number**

EP 25 21 9306

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | YIN XINYANG ET AL: "Voltage-fault diagnosis for battery pack in electric vehicles using mutual information", JOURNAL OF POWER SOURCES, vol. 608, 4 May 2024 (2024-05-04), page 234636, XP093392964, AMSTERDAM, NL ISSN: 0378-7753, DOI: 10.1016/j.jpowsour.2024.234636 | 1,11,12 | |
| A | * table 2 * | 3-9, 13-15 | |

-----

TECHNICAL FIELDS SEARCHED (IPC)

The present search report has been drawn up for all claims

| Place of search | Date of completion of the search | Examiner |
|---|---|---|
| The Hague | 30 April 2026 | Rambaud, Patrick |

EPO FORM 1503 03.82 (P04C01)

page 2 of 2

## ANNEX TO THE EUROPEAN SEARCH REPORT
## ON EUROPEAN PATENT APPLICATION NO.

EP 25 21 9306

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2026

| Patent document cited in search report | | Publication date | Patent family member(s) | | Publication date |
|---|---|---|---|---|---|
| EP 4614170 | A1 | 10-09-2025 | CN | 120595149 A | 05-09-2025 |
| | | | EP | 4614170 A1 | 10-09-2025 |
| | | | KR | 20250134373 A | 11-09-2025 |
| | | | US | 2025277859 A1 | 04-09-2025 |
| CN 117706387 | A | 15-03-2024 | NONE | | |

EPO FORM P0459

For more details about this annex : see Official Journal of the European Patent Office, No. 12/82